Europäisches Patentamt

European Patent Office

Office européen des brevets

(11) Veröffentlichungsnummer: **0 405 323 A2**

# (12) EUROPÄISCHE PATENTANMELDUNG

(21) Anmeldenummer: 90111712.7

(51) Int. Cl.5: **G01R 1/067**

(22) Anmeldetag: 21.06.90

(30) Priorität: 24.06.89 DE 3920850

(43) Veröffentlichungstag der Anmeldung:
02.01.91 Patentblatt 91/01

(84) Benannte Vertragsstaaten:
CH DE FR GB IT LI

(71) Anmelder: Feinmetall Gesellschaft mit
beschränkter Haftung
Zeppelinstrasse 2
D-7033 Herrenberg(DE)

(72) Erfinder: **Seeliger, Michael**
**Ganghofer Strasse 7**
**D-7413 Gomaringen(DE)**

(74) Vertreter: **Gleiss, Alf-Olav, Dipl.-Ing. et al**
**Patentanwaltskanzlei Gleiss & Grosse**
**Silberburgstrasse 187187**
**D-7000 Stuttgart 1(DE)**

(54) Federkontaktstift.

(57) Er weist eine Hülse auf, in der ein Kolbenglied
gleitbar geradegeführt und eine in der Hülse angeordnete Feder abgestützt ist. In die Hülse ist eine
Laufbuchse eingesetzt, in der ein Kolben des Kolbengliedes gleitbar geradegeführt ist. Die Laufbuchse ist im vorderen Endbereich der Hülse angeordnet
und zur exakten Geradführung des Kolbens oder
eines vorderen Kolbens des Kolbengliedes ausgebildet. Das Kolbenglied ist aus der Hülse unter Überwindung von zwischen der Laufbuchse und der Hülse vorliegender Ruhereibungskraft und/oder unter
seitlichem Ausbiegen mindestens eines federnden
Anschlages axial herausziehbar.

FIG.1

## FEDERKONTAKTSTIFT

Die Erfindung betrifft einen Federkontaktstift für Prüfadapter gemäß dem Oberbegriff des Anspruches 1.

Es gibt unterschiedliche Arten von Prüfadaptern. Im einfachsten Fall wird der Prüfling ausschließlich geprüft, während er eine einzige vorbestimmte Relativstellung zum Prüfadapter hat und von den zu seiner Kontaktierung vorgesehenen Federkontaktstiften und ggfs. auch noch anderen Kontaktstiften, bspw. als Nadeln oder Drähte ausgebildeten Kontaktstiften, kontaktiert wird. Es gibt jedoch auch Prüfadapter, bei denen der Prüfling unterschiedlichen Prüfungen unter Einsatz desselben Prüfadapters unterzogen werden kann, insbesondere sogenannte Doppelhub-Prüfadapter. Letztere sind so ausgebildet, daß der Prüfling zuerst einen vorbestimmten Abstand von der Frontplatte des Prüfadapters hat und in dieser Stellung durch eine Teilanzahl vorbestimmter Federkontaktstifte zur Durchführung eines Funktionstests kontaktiert wird. Ermittelt der Funktionstest fehlerfreie Funktion des betreffenden Prüflings, dann ist die Prüfung bereits beendet. Wird bei dem Funktionstest Fehlerhaftigkeit des Prüflings festgestellt, dann findet anschließend ein sogenannter In-Circuit-Test statt, bei dem der Prüfling näher an die Frontplatte des Prüfadapters in eine vorbestimmte zweite Stellung überführt wird, in der er noch durch weitere Federkontaktstifte oder sonstige Kontaktstifte kontaktiert wird und dieser zweite Test dient dazu, die Fehlerstelle zu ermitteln, um nach Möglichkeit eine gezielte Reparatur des Prüflings vornehmen zu können, bspw. um einen Defekt einer Leiterbahn beheben zu können.

Die Erfindung bezieht sich auf Federkontaktstifte, die für beliebige Prüfadapter geeignet sind, insbesondere auch für Doppelhub-Prüfadapter.

In der Praxis ist es oft erwünscht oder notwendig, daß man aus irgendwelchen Gründen die Federkontaktstifte einzeln auswechseln kann, bspw. einen beschädigten Federkontaktstift gegen einen neuen Federkontaktstift, einen Federkontaktstift einer bestimmten Länge oder einer bestimmten Gestalt seiner Kontaktspitze oder seines Kontaktkopfes gegen einen Federkontaktsift anderer Länge oder Kopfform, oder um die Bestückung des Prüfadapters mit Federkontaktstiften zu ändern, usw.

In der Praxis setzte man bisher immer dann, wenn leichte Auswechselbarkeit der in einem Prüfadapter angeordneten Federkontakstifte verlangt wurde, sogenannte Federkontaktstifte mit Überhülsen ein (GUSTAV KRÜGER "Prüfmittel zur elektrischen Prüfung von Leiterplatten für Uhren", Jahrbuch der Deutschen Gesellschaft für Chronometrie, Bd. 30, 1979, S.269/276). Jeder zur Anordnung in einer solchen Überhülse vorgesehene Federkontaktstift ist dabei ein kompletter Federkontaktstift, der eine eigene, in die Überhülse lösbar einsteckbare Hülse aufweist, in welcher mindestens eine Feder und das durch die Feder federbelastete Kolbenglied des Federkontaktstiftes eingesetzt ist. Das Kolbenglied ragt aus der Hülse heraus und sein vorderes freies Ende ist als Kontaktkopf oder Kontaktspitze ausgebildet, welches vordere freie Ende dem Inkontaktkommen mit zu kontaktierenden Prüflingen dient. Derartige Federkontaktstifte mit Überhülsen sind relativ teuer und beim Auswechseln eines Federkontaktstiftes wird ein kompletter neuer Federkontaktstift erforderlich.

Es ist auch ein Federkontaktstift bekannt, von dem im Oberbegriff des Anspruches 1 ausgegangen ist, und bei welchem das Kolbenglied und eine im unteren Endbereich der Hülse angordnete Laufbuchse aus der in dem Prüfadapter nicht lösbar angeordneten Hülse nach Lösen eines in die Hülse nahe ihrem vorderen Ende eingesetzten, einen Anschlag für das Kolbenglied bildenden C-Ringes herausziehbar ist (US-PS 4 183 609). Da solche Hülsen extrem kleine Aussendurchmesser von meist 0,7 bis 1, 5 mm bei sehr geringen Wandstärken von bspw. 0,1 mm und relativ grossen Längen von bspw. 30 bis 120 mm haben, besteht beim Herausnehmen des C-Ringes und der Laufbuchse aus der Hülse für die Hülse Beschädigungsgefahr, da hierzu mit von Hand bedienten Werkzeugen in die Hülse eingegriffen werden muß. Bereits eine geringe Beschädigung der Hülse kann sie wegen ihrer Dimensionen und den erforderlichen geringen Toleranzen unbrauchbar und ihr Auswechseln erforderlich machen, was, wenn überhaupt möglich, schwierig und zeitraubend ist. Das Kolbenglied dieses Federkontaktstiftes weist einen vorderen Kolben auf, der auf einer durch die Hülse gebildeten Laufbahn gleitet und dessen Durchmesser entsprechend etwas kleiner als der Innendurchmesser der Hülse ist. Dieser Kolben ist nur kurz und kann das Kolbenglied nicht mit der erforderlichen Exaktheit führen, weswegen das Kolbenglied einen von der Rückseite des vorderen Kolbens abstrebenden langen und sehr dünnen Schaft aufweist, auf den eine das Kolbenglied belastende Schraubendruckfeder aufgesteckt ist. Dieser Schaft steht über diese Feder nach rückwärts über und der überstehende Bereich ist in einer in den rückwärtigen Endbereich der Hülse eingesetzten Laufbuchse geführt. Diese Laufbuchse dient auch als Widerlager für das rückwärtige Ende der Schraubendruckfeder. Infolge dieses sehr langen und extrem dünnen, in die Laufbuchse eintauchenden Schaftes ist die spanabhebende Herstellung dieses Kolbengliedes schwierig und teuer. Auch kann der genannte lange und extrem dünne Schaft infolge seiner unvermeidlichen Flexibilität die Führung des vorderen Kolbens praktisch nicht verbessern, so daß die Gefahr ungenauer Führung des vorderen Kolbens durch die hintere Laufbuchse nicht behoben werden kann.

Es ist deshalb eine Aufgabe der Erfindung, einen Federkontaktstift der im Oberbegriff des Anspruches 1 genannten Art zu schaffen, dessen Kolbenglied problemlos exakt gleitbar geführt und auch wesentlich kostengünstiger hergestellt werden kann.

Diese Aufgabe wird erfindungsgemäß durch den in Anspruch 1 angegebenen Federkontaktstift gelöst.

Bei diesem Federkontaktstift ist die Laufbuchse im vorderen Endbereich der Hülse angeordnet und dient der exakten Geradführung des Kolbengliedes. Diese Laufbuchse benötigt nur wenig Material und kann deshalb aus hochwertigem Werkstoff hergestellt werden. Vorzugsweise kann für sie Neusilber, Kupferberyllium oder Bronze verwendet werden. Auch kann sie mit mindestens einer ihre Eigenschaften noch verbessernden Beschichtung, vorzugsweise aus Edelmetall, versehen sein. Es ist auch möglich, sie aus Sintermetall herzustellen und mit Schmiermittel zu tränken, so daß ihre Laufbahn für den in ihr geführten Kolben des Kolbengliedes geschmiert ist. Auch kann sie gewünschtenfalls aus Nichtmetall, insbesondere aus gute Gleiteigenschaften aufweisendem Nichtmetall, bspw. aus Polytetrafluoräthylen bestehen.

Der erfindungsgemäße Federkontaktstift ist so ausgebildet, daß das Kolbenglied aus der Hülse axial unter Kraftanwendung herausgezogen werden kann, ohne daß es hierzu vorher dem Herausnehmen eines anderen Teiles aus der Hülse bedarf. Hierdurch wird jede Beschädigungsgefahr für die Hülse beim Herausnehmen des Kolbengliedes auf einfache Weise vermieden. Das Kolbenglied kann zu diesem Zweck in seiner Ruhestellung, d.h. in seiner nicht durch einen Prüfling belasteten, sondern nur durch die in der Hülse befindliche Feder belasteten Stellung an mindestens einem Anschlag anliegen, an den er durch die Feder gedrückt wird und der diese Ruhestellung des Kolbengliedes gegen die Kraft der vorgespannten Feder hält, jedoch kann die Kraft, mit der der Anschlag das Kolbenglied hält, dadurch überwunden werden, indem man das Kolbenglied mittels einer manuell bedienten feinen Zange oder dgl. mit ausreichend grosser Kraft manuell axial aus der Hülse herauszieht. Der Anschlag kann dabei so ausgebildet sein, vorzugsweise durch die Laufbuchse gebildet sein, daß er durch das Kolbenglied, wenn man dieses aus der Hülse herauszieht, mit herausgezogen wird. Oder der Anschlag ist ein federnder Anschlag, der durch das Kolbenglied federnd seitlich nach aussen gedrückt wird, wenn man es mit hierfür ausreichender Kraft aus der Hülse axial herauszieht.

Die Laufbuchse kann in die Hülse nichtlösbar oder lösbar eingesetzt sein. Wenn sie lösbar eingesetzt ist, kann zweckmässig vorgesehen sein, daß sie beim Herausziehen des Kolbengliedes aus der Hülse durch dieses Kolbenglied aus der Hülse mit herausgeschoben wird, so daß auch zum Herausnehmen der Laufbuchse nicht mit einem Werkzeug in die Hülse eingegriffen werden muß.

Der erfindungsgemäße Federkontaktstift benötigt für die Auswechselbarkeit des Kolbengliedes keine Überhülse, so daß vorzugsweise seine Hülse zum direkten Einsetzen in eine Bohrung mindestens einer Platte eines Prüfadapters ausgebildet sein kann.

Im Falle der lösbaren Anordnung der Laufbuchse kann sie vorzugsweise in der Hülse reibungsschlüssig gehalten sein oder durch mindestens einen federnden Anschlag der Hülse, welcher Anschlag beim Herausschieben der Laufbuchse aus der Hülse durch die Laufbuchse federnd seitlich nach aussen gedrückt wird.

Die Erfindung ermöglicht es, daß das Kolbenglied und, falls auch Lösbarkeit der Laufbuchse vorgesehen ist, auch sie aus der Hülse des Federkontaktstiftes herauszunehmen, ohne daß hierzu mittels eines Werkzeugs in die Hülse eingegriffen werden muss. Es genügt für dieses Herausnehmen, das Kolbenglied an seinem über die Hülse überstehenden Bereich mittels eines von Hand bedienten Werkzeuges zu ergreifen und unter Kraftanwendung axial aus der Hülse herauszuziehen. Das Wiedereinsetzen des Kolbengliedes oder eines anderen Kolbengliedes und ggfs. der Laufbuchse in die Hülse kann entsprechend ebenfalls ohne Werkzeugeingriff in die Hülse nur durch Einschieben des Kolbengliedes und ggfs. der Laufbuchse in sie erfolgen. Dies alles ist auch dann und insbesondere dann möglich, wenn solche erfindungsgemässen Federkontaktstifte in einem Prüfadapter in beliebig geringen Mittenabständen nebeneinander angeordnet sind.

Die Hülse des Federkontaktstiftes kann lösbar oder nicht lösbar in eine Bohrung der Frontplatte eines Prüfadapters eingesetzt sein. Sie kann nur an dieser Frontplatte gehalten oder auch noch zusätzlich an mindestens einer weiteren Platte des Prüfadapters gehalten sein. Wesentlich ist, daß das Kolbenglied und ggfs. auch die Laufbuchse des Federkontaktstiftes insbesondere dann, wenn er in eine Frontplatte eines Prüfadapters zwischen anderen, ihm eng benachbarten Federkontaktstiften eingesetzt ist, trotzdem auf einfache Weise rasch und kostengünstig aus der unbeweglich in der Frontplatte verbleibenden Hülse herausgenommen und dieses Kolbenglied und ggfs. auch die Laufbuchse bzw. ein neues Kolbenglied und ggfs. eine neue Laufbuchse wieder in die Hülse leicht und problemlos eingesetzt werden können. Bspw. besteht bei solchen Federkontaktstiften die Gefahr, daß das Kolbenglied beschädigt wird oder zu stark abgenutzt wurde und deshalb ausgewechselt werden muß oder daß die Feder bricht und deshalb ausgewechselt werden muß. Beides ist bei dem erfindungsgemäßen Federkontaktstift auf einfache Weise möglich, indem das Kolbenglied in der Hülse leicht auswechselbar gehalten ist. Es genügt, das Kolbenglied aus der Hülse herauszuziehen und es kann dann ein neues Kolbenglied in die Hülse eingesteckt werden. Wenn die Feder gebrochen war, kann man ihre gebrochenen Teile leicht aus der Hülse mittels eines geeigneten Werkzeuges, das keine Beschädigungsgefahr der Hülse hervorruft, bspw. mittels dünnen, hakenförmig gebogenen Drähtchens oder mittels eines winzigen Magneten herausziehen oder sie aus der Hülse herausfallen lassen und eine neue Feder einsetzen und dann das gleiche oder ein anderes Kolbenglied wieder einsetzen. Auch wenn durch Verschleiß das Spiel des Kolbens in der Laufbuchse zu groß geworden ist und hierdurch unter Umständen der elektrische Übergangswiderstand unerwünscht stark angestiegen ist, kann man das Kolbenglied und ggfs. die Laufbuchse aus der Hülse herausnehmen und gegen ein neues Kolbenglied und ggfs. gegen eine neue Laufbuchse auswechseln.

In vielen Fällen ist es auch erwünscht, daß an derselben Stelle des Prüfadapters Federkontaktstifte mit unterschiedlich geformten vorderen Enden ihrer Kolbenglieder angeordnet werden oder mit unterschiedlich langen Kolbengliedern angeordnet werden können, um sie zu kontaktierenden Stellen unterschiedlicher Prüflinge anpassen zu können. Auch hier schafft die Erfindung die einfache Möglichkeit, das jeweilige Kolbenglied gegen ein neues, bspw. unterschiedlich langes oder eine andere Ausbildung des vorderen freien Endbereiches aufweisendes Kolbenglied auf einfache Weise und ohne Beschädigungsgefahr der Hülse auswechseln zu können.

In der Zeichnung sind Ausführungsbeispiele der Erfindung dargestellt. Die Figuren 1 bis 6 zeigen je einen Federkontaktstift in längsgeschnittener und gebrochener Seitenansicht gemäß Ausführungsbeispielen der Erfindung.

Übereinstimmend besteht jeder der in den Figuren 1, 2 4 und 5 dargestellten Federkontaktstifte 10 aus einer Hülse 11, einer Laufbuchse 12, einem Kolbenglied 13 und einer vorgespannten zylindrischen Schraubendruckfeder 14. Dagegen weist jeder der Federkontaktstifte 10 nach den Figuren 3 und 6 außer einer Hülse 11, einer Laufbuchse 12 (die man auch als Lagerbuchse bezeichnen kann), einem Kolbenglied 13 und einer vorgespannten zylindrischen Schraubendruckfeder 14, zusätzlich noch einen in dem rückwärtigen Endbereich der Hülse 11 geradegeführt gleitbar gelagerten Kontakt 22 auf, an dem sich die Feder 14 mit ihrem rückwärtigen Ende abstützt und der ein mittiges Loch im Boden der Hülse 11 mit einem zylindrischen Vorsprung durchdringt und durch die Feder 14 an einen an einer rückwärtigen Platte 21 des Prüfadapters fest angeordneten Gegenkontakt 20 zum elektrischen Anschluß des Federkontaktstiftes 10 angedrückt ist.

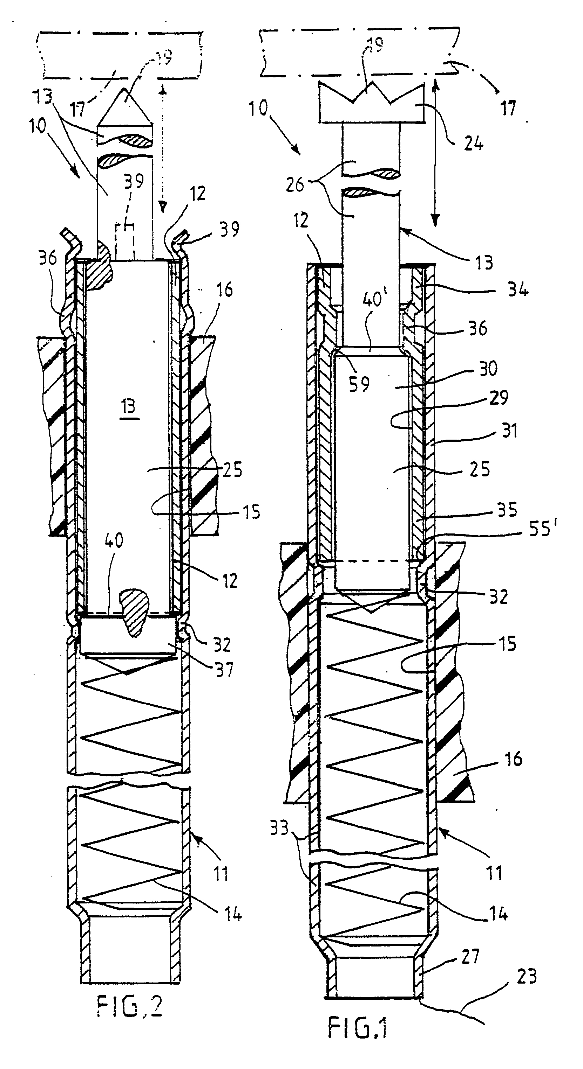

Jeder der in den Figuren 1 bis 6 dargestellten Federkontaktstifte 10 ist in eine von ihm durchdrungene Bohrung 15 einer Frontplatte 16 eines nicht in weiteren Einzelheiten dargestellten Prüfadapters fest eingesetzt. Der Prüfadapter kann mit Ausnahme der neuartigen Federkontaktstifte 10 von an sich bekannter Bauart sein. Die Hülse 11 des jeweiligen Federkontaktstiftes 10 ist in der von ihr durchdrungenen Bohrung 15 unbeweglich gehalten.

Der Prüfadapter kann ein Doppelhub-Prüfadapter sein, aber auch ein sonstiger Prüfadapter, der kein Doppelhub-Prüfadapter ist. Solche Prüfadapter weisen im allgemeinen sehr große Anzahlen von Federkontaktstiften auf, meist mehrere hundert bis viele tausend Federkontaktstifte, beispielsweise oft auch mehr als hunderttausend Federkontaktstifte.

Um sicheren elektrischen Kontakt der jeweils durch einen Federkontaktstift 10 zu kontaktierenden Stelle eines Prüflings 17 (Figur 1, 2, 5), beispielsweise einer Leiterplatte, zu erreichen, wird das vordere Kontaktende 19 des Kolbengliedes 13 des betreffenden Federkontaktstiftes 10 durch die Schraubendruckfeder 14 beispielsweise mit einer Kraft von 50 bis 300 cN an den Prüfling 17 angedrückt. Die große Anzahl der Federkontaktstifte 10 eines Prüfadapters bedingt deshalb oft außerordentlich große Gesamtkraft, mit der der Prüfling 17 an die Kontaktenden 19 der Federkontaktstifte 10 angedrückt werden muß, um sichere elektrische Kontakte zu erreichen. Diese große Gesamtkraft wird deshalb bei Prüfadaptern meist mittels pneumatischem Unterdruck erzeugt, der in dem nach außen luftdicht abgedichteten Zwischenraum zwischem dem Prüfling 17 und der Frontplatte 16 erzeugt wird und den Prüfling 17 an die Kontaktenden 19 der Kolbenglieder 13 der Federkontaktstifte 10 andrückt, wozu der Prüfling 17 und die Frontplatte 16 in Längsrichtung der zueinander parallelen, in die Frontplatte 16 jeweils fest eingesetzten Federkontaktstifte 10 relativ zueinander beweglich sind. In diesem Falle müssen also die Federkontaktstifte 10 luftdicht in die Bohrungen 15 der betreffenden Frontgesamtplatte 16 eingesetzt sein, also spielfrei so fest eingesetzt sein, daß man sie nicht mehr oder nicht mehr ohne weiteres oder nicht mehr ohne Beschädigungsgefahr aus der Frontplatte 16 wieder herausziehen kann. Andererseits tritt häufig der Fall auf, daß ein Federkontaktstift nach vielen Kontaktierungen von Prüflingen nicht mehr einwandfrei arbeitet. Und zwar dient der Federkontaktstift 10 bei der Prüfung eines Prüflings als Teil einer elektrisch möglichst gut leitenden Verbindung zwischen der von ihm jeweils kontaktierten Stelle des betreffenden Prüflings und einem elektronischen Prüfschaltungssystem, das die elektrischen Signale für die Prüfung des jeweiligen Prüflings erzeugt und daraufhin auswertet, ob der Prüfling elektrisch fehlerfrei ist oder nicht.

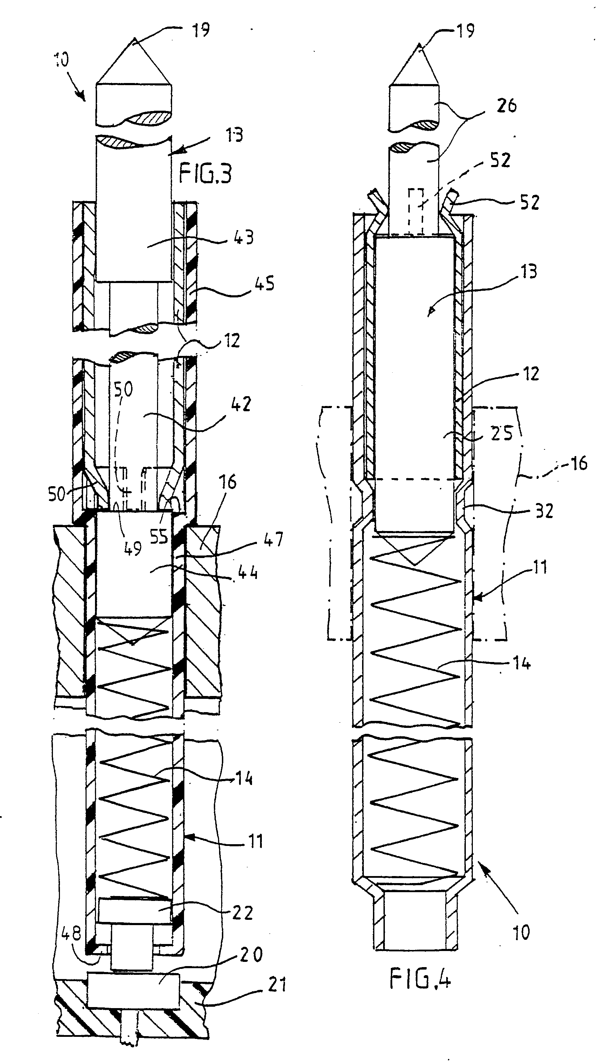

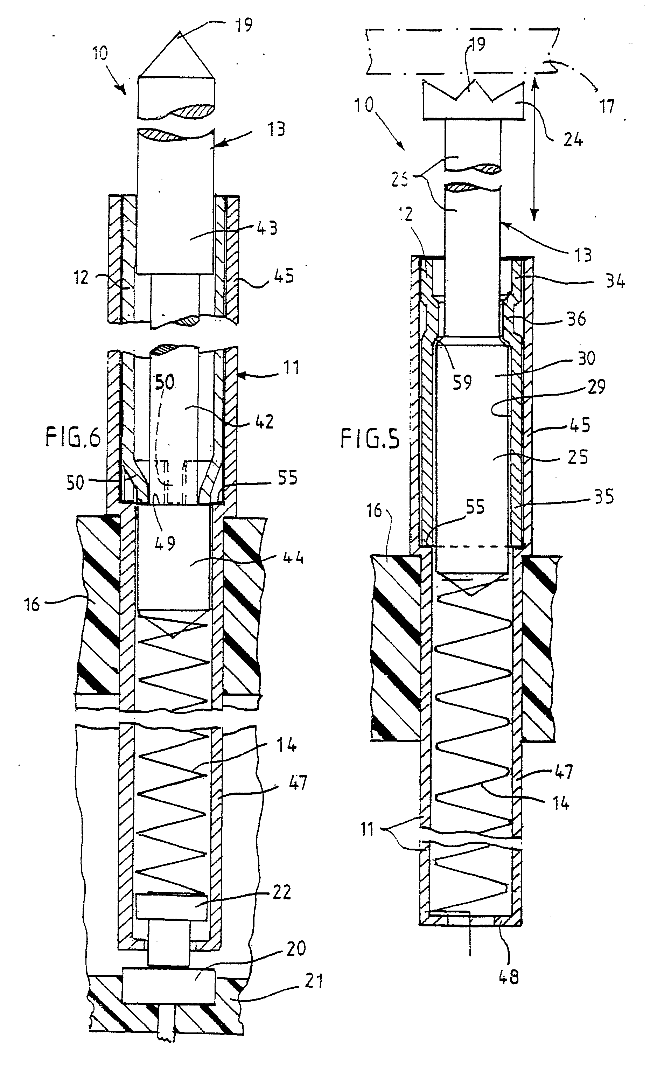

Deshalb dürfen die Federkontaktstifte 10 zwischen dem Kontaktende 19 und den Anschlußstellen, an denen sie an weiterführende elektrische Leiter elektrisch angeschlossen sind, nur relativ geringe elektrische Widerstände haben, und zwar möglichst geringe. Als Beispiel eines solchen weiterführenden Leiters ist in Figur 1 an das rückwärtige Ende der Hülse 11 des Federkontaktstiftes 10 ein elektrischer Leitungsdraht 23 angelötet und in Figur 3 bzw. 6 ist der Kontakt 22 des Federkontaktstiftes 10 an den elektrisch leitenden Gegenkontakt 20 angedrückt, welcher Gegenkontakt 20 mit dem Prüfschaltungssystem in nicht weiter dargestellter Weise elektrisch leitend verbunden ist.

Im Laufe der Betriebs zeit eines Prüfadapters erhöht sich im allgemeinen der elektrische Widerstand seiner Federkontaktstifte 10 und dies kann zum Unbrauchbarwerden einzelner Kontaktstifte führen. Die Ursache hierfür liegt im Verschleiß des Federkontaktstiftes, also seiner aufeinandergleitenden Gleitflächen oder in zu starker Abnutzung seines vorderen Kontaktendes 19. Auch kann es oft zum Ermüdungsbruch der Feder 14 kommen. Oft ist auch erwünscht, die Gestalt des vorderen Kontaktendes 19 eines Kontaktstiftes 10 zu wechseln, beispielsweise anstatt der Kegelspitze des Kolbengliedes 13 des Federkontaktstiftes nach Figur 2 ein Kolbenglied 13 mit einem Kontaktkopf 24 gemäß des Kolbengliedes 13 des Federkontaktstiftes nach Figur 1 oder mit einer sonstigen Gestaltung zu haben. Oder bei Doppelhub-Prüfadaptern kann auch der Fall eintreten, daß die Länge des in der Normalstellung des Kolbengliedes 13 über die Hülse 11 überstehenden Bereiches des Kolbengliedes 13 geändert wird. Die dargestellten Federkontaktstifte ermöglichen dies auf einfache Weise durch problemlose Auswechselbarkeit der Kolbenglieder 13, wobei infolge der die Kolbenglieder 13 im vorderen Bereich der Hülsen 11 genau mit geringem Gleitlagerspiel führenden Laufbuchsen 12 exaktes Kontaktieren der zu kontaktierenden Stellen der Prüflinge 17 sichergestellt ist, da keine Gefahr von Taumelbewegungen, d.h. des Vorliegens oder Entstehens von sogenanntem "Taumelspiel" der Kolbenglieder 13 in den Hülsen 11 infolge der Laufbuchse 12 besteht.

Dabei sind die Federkontaktstifte 10 so ausgebildet, daß man ihre Kolbenglieder 13 mittels eines einfachen Werkzeuges, beispielsweise einer kleinen Zange, aus den in der Frontplatte 16 des betreffenden Prüfadapters unverändert bleibenden Hülse 11 herausziehen und ein neues Kolbenglied 13 gleicher oder geänderter Gestalt einstecken kann. Das Werkzeug greift dabei nicht in die Hülse 11 ein, so daß für sie dabei keine Beschädigungsgefahr besteht.

Bei den Federkontaktstiften 10 nach den Figuren 1, 2 und 4 bis 6 sind alle ihre Teile 11 bis 14 bzw. 11 bis 14 und 22 metallisch, wogegen bei dem Federkontaktstift 10 nach Figur 3 seine Hülse 11 nichtmetallisch ist, hier aus elektrisch nicht leitendem Kunststoff besteht. Die übrigen Teile 12 bis 14 und 22 dieses Federkontaktstiftes 10 nach Figur 3 sind jedoch metallisch. Diese nichtmetallische Hülse 11 kann ggfs. auch aus anderem geeigneten Nichtmetall bestehen, bspw. aus Keramik. Die nichtmetallische Ausbildung der Hülse 11 hat u.a. den Vorteil, daß die Frontplatte 16 die Federkontaktstifte nicht gegeneinander elektrisch isolieren muss und so beispielsweise kostengünstig aus Metall bestehen kann.

Es kann in manchen Fällen oft zweckmäßig auch vorgesehen sein, daß die Laufbuchse 12 nichtmetallisch ist, vorzugsweise aus einem Werkstoff mit besonders guter mechanischer Gleitfähigkeit besteht, beispielsweise oft zweckmäßig aus Polytetrafluoräthylen. Oder sie kann bspw. oft zweckmäßig auch aus mit Schmiermittel getränktem Sintermetall bestehen, wie es für Gleitlager an sich bekannt ist. Und zwar reicht es für die elektrische Leitfähigkeit des Federkontaktstiftes über seine Länge aus, wenn sein Kolbenglied 13 und seine Feder 14 aus Metall bestehen und ggf. der die Feder elektrisch anschließende Kontakt 22 in Figur 3 noch vorhanden ist. Dieser Kontakt 22 kann in vielen Fällen jedoch auch entfallen, indem man beispielsweise gemäß Fig. 5 die Feder 14 mit einem abgewinkelten Ende nach außen aus der Hülse 11 herausführt, so daß an dieses Ende ein elektrisch weiterführender Draht oder Kontakt angeschlossen sein kann, beispielsweise dieses Ende auf einen Gegenkontakt drückt, der dem Gegenkontakt 20 nach Fig. 6 entsprechen kann. Oder es kann an die Feder 22 ein weiterführender sonstiger Leiter angelötet oder angeschweißt sein, beispielsweise ein elektrischer Draht.

Im Ausführungsbeispiel nach Figur 1 besteht das massive Kolbenglied 13 aus dem in der Laufbuchse 12 gleitbar gelagerten Kolben 25, dem mit dem Kolben 25 einstückigen Schaft 26 und dem an dem kreiszylindrischen Schaft 26 befestigten Kontaktkopf 24. Die auf der kreiszylindrischen Laufbahn 29 der Laufbuchse 12 gleitende Gleitfläche 30 des Kolben 25 ist ebenfalls kreiszylindrisch. Das Kolbenglied 13, dessen Kontaktkopf 24 in diesem Ausführungsbeispiel im Durchmesser relativ zum Schaft 26 verbreitert ist und mehrere Spitzen oder Schneiden aufweist, die dem Inkontaktkommen mit dem jeweiligen Prüfling 17 dienen, wird ausschließlich in der Laufbuchse 12 durch deren Laufbahn 29 geradegeführt. Diese Laufbuchse 12 befindet sich, wie auch in den anderen Ausführungsbeispielen, im vorderen Endbereich der Hülse 11 im Abstand vor der an die kegelförmige Unterseite des Kolbens 25 des Kolbengliedes 13 ständig angedrückten Feder 14. Die Hülse 11 weist von ihrem oberen Ende aus zunächst einen kreiszylindrischen Bereich 31 auf, über dessen Länge sich die Laufbuchse 12 erstreckt. An diesen Bereich 31 schließt eine Verengung in Form einer kreisrunden Sicke 32 an, die in der Hülse einen Innenwulst bildet, an dem die Laufbuchse 12 anliegt, derart, daß der obere Rand der in der Hülse 11 befindlichen Innenwand der Sicke 32 eine Ringschulter 55, bildet, die einen axialen Anschlag für die Laufbuchse 12 und damit für deren Lage in der Hülse 11 bildet. An diese Sicke 32 schließt ein langer kreiszylindrischer, die Feder 14 enthaltender Bereich 33 der Hülse 11 an, der denselben Aussendurchmesser wie der Bereich 31 hat. An diesen Bereich 33 schließt ein im Durchmesser etwas verengter kürzerer Endbereich 27 an, an den der Leitungsdraht 23 angeschlossen ist, der jedoch auch andere elektrische Anschlußmöglichkeiten dieses Federkontaktstiftes 10 ermöglicht.

In den oberen Bereich 31 der Hülse 11 ist die Laufbuchse 12 in einem Haftreibungssitz eingesetzt und durch die Haftreibung in der Hülse 11 gehalten.

Diese einstückige metallische Laufbuchse 12 weist zwei kreiszylindrische Bereiche 34 und 35 derselben Innen-und Außendurchmesser auf, die durch eine einen Innenringwulst bildende Sicke 36 miteinander verbunden sind. In den unteren langen kreiszylindrischen Bereich 35 ist der Kolben 25 eingesetzt und dieser untere Bereich 35 bildet so an seiner Innenfläche die Laufbahn 29 der Laufbuchse 12 für die Gleitfläche 30 des Kolbens 25. Die durch die Sicke 36 an der Innenwand der Laufbuchse 12 gebildete Ringschulter 59 bildet für den Kolben 25 einen oberen Anschlag, an den die am Übergang vom Kolben 25 zum Schaft 26 vorhandene Ringschulter 40' des Kolbengliedes 13 durch die vorgespannte Feder 14 angedrückt ist, solange das Kolbenglied 13 nicht durch einen Prüfling 17 beim Kontaktieren dieses Prüflinges relativ zur Hülse 11 nach unten gedrückt wird.

Die Kraft, die die Feder 14 in der dargestellten Ruhestellung des Kolbengliedes 13 auf dieses in axialer Richtung ausübt, ist nicht so groß, daß sie die Laufbuchse 12 in der Hülse 11 verschieben kann, da die Ruhereibungskraft zwischen der Laufbuchse 12 und der Hülse 11 hierzu durch entsprechenden Haftsitz zu groß vorgesehen ist. Dagegen kann man mit einem geeigneten feinen Werkzeug, beispielsweise einer Zange, den Kontaktkopf 24 des Kolbengliedes 13 erfassen und es mit so großer Kraft von Hand nach oben ziehen, daß es dabei infolge des Anliegens des Kolbens an der durch die Sicke 36 gebildeten Innenringschulter 59 der Laufbuchse 12 diese Laufbuchse 12 mit aus der Hülse 11 herauszieht. Die Hülse 11 ist so fest in der Frontplatte 16 gehalten, daß sie hierbei unverändert in derselben Stellung in der Frontplatte 16 verbleibt. Man kann dann ein neues Kolbenglied 13 zusammen mit einer Laufbuchse 12 in diese im Prüfadapter weiterhin befindliche Hülse 11 einsetzen, so daß der Federkontaktstift 10 dann wieder komplett und betriebsbereit ist.

Die Laufbuchse 12 benötigt nur sehr wenig Material und ist einfach herstellbar. Sie kann aus hochwertigem Material hergestellt werden, das nur geringem Verschleiß unterliegt und den Kolben mit geringem Gleitlagerspiel exakt geradeführt und günstig gleitlagert, wobei ggfs. ihre Laufffläche auch noch mit einer ihre Eigenschaften noch verbessernden Beschichtung bspw. aus Edelmetall versehen sein kann. Die Laufbuchse 12 kann beispielsweise vorteilhaft aus Neusilber, Bronze oder Kupferberyllium bestehen oder auch aus Schmiermittel enthaltendem Sintermetall. Das Kolbenglied 13 kann ebenfalls aus hochwertigem Metall bestehen, das geringem Verschleiß unterliegt und ggfs. mit Edelmetall oder mit sonstigem Metall beschichtet sein kann. Bspw. kann das Kolbenglied 13 aus Kupferberyllium, Neusilber, Stahl oder dgl. bestehen. Die Hülse 11 unterliegt infolge der Laufbuchse 12 selbst keinem Verschleiß. Auch nimmt sie an der Gleitlagerung des Kolbens 25 nicht teil, so daß man sie aus kostengünstigem, leicht bearbeitbarem oder verarbeitbarem Material herstellen kann, wie z.B. Messing oder Stahl.

Es sei hier noch bemerkt, daß solche Federkontaktstifte 10 in der Frontplatte 16 meist an Rasterpunkten eines vorbestimmten Rasters angeordnet sind. Das Rastermaß kann beispielsweise 1,5 bis 3 mm betragen und je nach Fall auch noch größer oder noch kleiner sein. Es können dann am Prüfadapter stellenweise die Federkontaktstifte so eng nebeneinander angeordnet sein, daß man ihre Köpfe 24 nicht direkt von Hand erfassen kann und zumindest in solchen Fällen auf die Zuhilfenahme eines feinen Werkzeuges zum Herausziehen eines Kolbengliedes 13 zusammen mit der Laufbuchse 12 aus der betreffenden, ständig in der Frontplatte 16 verbleibenden Hülse 11 angewiesen ist, was auch aus sonstigen Gründen im allgemeinen zweckmäßig ist.

Da die Sicke 32 der Hülse 11 einen axialen Anschlag für die Laufbuchse 12 bildet, schiebt das Kolbenglied 13, wenn man es aus der Hülse 11 axial herauszieht, die Laufbuchse 12 axial mit aus der Hülse 11 heraus, was äußerst vorteilhaft ist, da man hierdurch kein eigenes Werkzeug für die Herausnahme der Laufbuchse 12 aus der Hülse benötigt und hierzu auch nicht in die Hülse 11 mit einem Werkzeug eingreifen muss, so daß keine Gefahr der Beschädigung der Hülse 11 besteht, wenn man das Kolbenglied zusammmen mit der Laufbuchse 12 aus ihr herauszieht. Würde dagegen Beschädigungsgefahr für die Hülse 11 durch ein in sie einzuführendes Werkzeug bestehen, müsste man die beschädigte Hülse ebenfalls auswechseln, was jedoch, falls es überhaupt möglich sein sollte, sehr schwierig und zeitraubend wäre.

Zur Herausnahme des Kolbengliedes 13 und der Laufbuchse 12 aus der Hülse 11 sind also keine weiteren Maßnahmen erforderlich, als nur das Kolbenglied 13 axial nach oben aus der Hülse 11 herauszuziehen, wobei es auch die Laufbuchse 12 mit herauszieht. Das Einsetzen eines Kolbengliedes 13 zusammmen mit einer Laufbuchse 12 in die Hülse 11 macht nur axiales Einsetzen der Laufbuchse 12 mit dem von ihr dabei mitgeführten Kolbenglied 13 in die Hülse 11 erforderlich, was ebenfalls mittels eines feinen Werkzeuges von außerhalb der Hülse 11 erfolgen kann. Es ist so völlig unproblematisch, am mit Federkontaktstiften bestückten Prüfadapter das Herausziehen und Wiedereinsetzen von Kolbengliedern 13 und Laufbuchsen 12 vorzunehmen. Alle diese Arbeiten können von oberhalb der betreffenden Hülsen 11 aus erfolgendes axiales Bewegen von Hand geführten Werkzeugen erfolgen, die nicht in die Hülse 11 eindringen.

Falls die Feder 14 ausgewechselt werden soll, dann kann man hierzu den Prüfadapter nach Herausnahme des Kolbengliedes 13 mit Laufbuchse 12 auf den Kopf stellen, so daß die Feder 14 herausfällt oder man kann sie mit einem hakenförmigen dünnen Drähtchen, das die Hülse 11 nicht beschädigen kann, aus der Hülse 11 herausziehen.

Der Federkontaktstift 10 nach Figur 2 unterscheidet sich von dem nach Figur 1 im wesentlichen in folgenden Einzelheiten.

Das Kolbenglied 13 weist ein dem Inkontaktkommen mit Prüflingen 17 dienendes unverdicktes konisches spitzes freies Ende 19 auf.

Die einstückige Laufbuchse 12 ist in diesem Ausführungsbeispiel durchgehend kreiszylindrisch und sie ist bis zu einem durch einen Innenringwulst 32 der Hülse 11 gebildeten unteren Anschlag in die Hülse 11 eingeschoben. In dieser eingeschobenen Stellung wird die Laufbuchse 12 durch federnde Zungen 39 gehalten, die seitlich federnde obere Anschläge für die Laufbuchse 12 bilden und vom oberen Rand der Hülse 11 einstückig mit ihr zuerst schräg in Richtung auf die Längsachse des Kolbengliedes 13 zu gerichtet sind und dann in schräg nach außen aufwärts führender Richtung umgebogen sind. In diesem Ausführungsbeispiel sind vier solche federnden Zungen in Winkelmittenabständen von jeweils 90 Grad Zentriwinkel angeordnet. Die Zahl der Zungen 39 kann jedoch auch größer oder kleiner sein. Im einfachsten Fall genügt eine einzige solche Zunge 39.

Das Kolbenglied 13 weist an seinem unteren Endbereich einen im Durchmesser etwas vergrößerten Endabschnitt 37 auf, der eine Ringschulter 40 bildet, die durch die Feder 14 an den unteren Rand der Laufbuchse 12 angedrückt ist. Dieser untere Rand der Laufbuchse 12 bildet so einen die Aufwärtsbewegung des Kolbengliedes 13 begrenzenden Anschlag. Die Feder 14 vermag jedoch nicht die Laufbuchse 12 in der Hülse aufwärts zu verschieben, da sie die Federkraft der federnden Zungen 39 nicht überwinden kann, d.h., daß die Federkraft der federnden Zungen 39 so ausgelegt ist, daß die Kraft der Feder 14 auf die Laufbuchse 12 diese federnden Zungen 39 nicht beiseite drükken kann. Die Reibung zwischen der Laufbuchse 12 und der Hülse 11 kann deshalb beliebig klein sein, so daß diese Ausführungsform den Vorteil größerer zulässiger Toleranzen gegenüber dem Ausführungsbeispiel nach Figur 1 an diesen Stellen des Federkontaktstiftes 10 hat. Dagegen kann man das Kolbenglied 13 wie bei allen Federkontaktstiften 10 nach den Ausführungsbeispielen nach Figuren 1 bis 4 mittels eines geeigneten feinen Werkzeuges von Hand nach oben aus der unverändert in der Frontplatte 18 verbleibenden Hülse 11 herausziehen, wobei es mittels seiner Ringschulter 40 auch die Laufbuchse 12 mit aus der Hülse 11 herausschiebt Die Montage des Kolbengliedes 13 mit der Laufbuchse 12 erfolgt umgekehrt, wobei es nicht einmal erforderlich ist, die federnden Zungen 39 von Hand oder mittels eines Werkzeuges nach außen zu drücken, da ihre freien, schräg nach oben auswärts führenden Schenkel beim Einsetzen durch die untere Stirnseite des den einzigen Kolben 25 aufweisenden Kolbengliedes 13 federnd nach außen gedrückt werden, wie auch durch die Laufbuchse 12, wenn diese mittels eines geeigneten Werkzeuges axial nach unten in Hülse 11 eingeschoben wird.

Bei diesem Ausführungsbeispiel nach Figur 2 weist ferner die Hülse 11 einen nach außen gewölbten Ringwulst 38 auf, der zum einen einen Anschlag für die Einstecktiefe der Hülse 11 in die Frontplatte 16 bildet und zum anderen die luftdichte Abdichtung der Hülse 11 in der Bohrung 15 der Frontplatte 16 verbessert, falls solche luftdichte Abdichtung vorgesehen ist.

Bei dem Federkontaktstift 10 nach Figur 3 weist das Kolbenglied 13 anstatt eines einzigen Kolbens zwei kreiszylindrische Kolben 43, 44 auf, die durch einen im Durchmesser kleineren kreiszylindrischen, zu ihnen koaxialen Schaft 42 verbunden sind. Der obere Kolben 43 reicht bis zur kegelförmigen Kontaktspitze 19 des einstückigen Kolbengliedes 13. Die Hülse 11 ist in diesem Ausführungsbeispiel so ausgebildet, daß sie aus einem oberen kreiszylindrischen Bereich 45 und einem an sie abgestuft anschließenden unteren kreiszylindrischen Bereich 47 kleineren Innendurchmessers und auch kleineren Aussendurchmessers und dem den letzteren Bereich nach unten bis auf eine mittige Öffnung abschließenden Boden 48 besteht. In dem Bereich 47 der Hülse 11 sind die sich am Boden 48 abstützende und ständig gegen die kegelförmige untere Stirnseite des Kolbengliedes 13 drückende Feder 14 und der untere Kolben 44 angeordnet.

Dieser untere Kolben 44 ist in dem Bereich 47 der Hülse 11 gleitbar geradegeführt, also nicht in der Laufbuchse 12, da der obere, in der Laufbuchse 12 mit geringem Gleitlagerspiel geführte Kolben 43 für die exakte Führung des Kolbengliedes 13 zusammen mit der Laufbuchse 12 maßgebend ist. Der untere Kolben 44 spielt für die Führung des Kolbengliedes keine Rolle oder nur eine untergeordnete Rolle und hat im wesentlichen nur die Aufgabe, beim Herausziehen des Kolbengliedes 13 aus der Hülse 11 die Laufbuchse 12 mit herauszuschieben, und zwar mittels der durch ihn am oberen Ende gebildeten Ringschulter 49, die auch die Aufgabe hat, die Aufwärtsbewegung des Kolbengliedes 13 im normalen Betrieb des Prüfadapters durch Inanschlagkommen an Zungen 50 der Laufbuchse 12 zu begrenzen. Und zwar ermöglicht es der im Durchmesser verkleinerte Schaft 42, daß an der Laufbuchse untenseitig einstückig mit ihr mindestens eine abgekröpfte, vorzugsweise federnde Zunge 50 - in diesem Ausführungsbeispiel sind vier solche Zungen in gleichen Zentriwinkelabständen um den Schaft 42 verteilt vorgesehen - angeordnet sein kann. Diese Laufbuchse 12 bildet so auch einen Anschlag für den Kolben 44.

Die Laufbuchse 12 ist bis zu der für sie einen Anschlag bildenden Innenringschulter 55 der Hülse 11 in diese eingeschoben und ist in diesem Ausführungsbeispiel wie bei dem Federkontaktstift 10 nach Figur 1 mit solcher Ruhehaftreibung in der Hülse 11 gehalten, daß die Feder 14 trotz ihrer Vorspannung diese Ruhehaftreibung nicht überwinden kann. Wenn dagegen das Kolbenglied 13 von Hand mittels eines feinen Werkzeuges aus der Hülse 11 axial nach oben herausgezogen wird, dann schiebt es hierbei die Laufbuchse 12 aus der Hülse 11 unter Überwindung der Ruhehaftreibung mit heraus. Die Montage erfolgt wieder umgekehrt.

Während bei den Federkontaktstiften nach den Figuren 1 bis 3 das Kolbenglied 13 bei seinem Herausziehen aus der Hülse 11 jeweils auch die zugeordnete Laufbuchse 12 mit herauszieht, ist dies bei dem in eine Bohrung einer strichpunktiert angedeuteten Frontplatte 16 eingesetzten Federkontaktstift 10 nach Figur 4 nicht der Fall. Hier ist die einstückige Laufbuchse 12 an ihrem oberen Rand mit mindestens einer, vorzugsweise mit mehreren federnden Zungen 52 der dargestellten Gestalt versehen. Beispielsweise können vier federnde Zungen 52 in Zentriwinkelmittenabständen von ca. 90 Grad voneinander vorgesehen sein. Diese federnden Zungen 52 bilden seitlich federnde Anschläge für die durch die Feder 14 bewirkte Ruhestellung des Kolbengliedes 13, wenn es also nicht durch einen Prüfling weiter in die Hülse 11 hineingedrückt ist. Die Vorspannung der Feder 14 reicht jedoch nicht aus, das Kolbenglied 13 gegen die Kraft der Zungen 52 weiter nach oben zu bewegen. Jedoch kann die Kraft der Zungen 52 leicht überwunden werden, wenn man das Kolbenglied 13 mittels eines Werkzeuges an seinem gegenüber dem einzigen Kolben 25 im Durchmesser verkleinerten Schaft 26 ausserhalb der Hülse 11 anpackt und nach oben aus der Hülse 11 herauszieht, wobei die Laufbuchse 12 in der Hülse 11 in unveränderter Stellung verbleibt, da in diesem Ausführungsbeispiel angenommen ist, daß die Laufbuchse 12 in der Hülse 11 mit solcher Haftung sitzt, insbesondere in einem Festsitz oder Preßsitz, daß sie beim Herausziehen des Kolbengliedes 13 aus ihr nicht mitgenommen wird, sondern unverändert in der Hülse 11 verbleibt. Die Laufbuchse 12 besteht hier zweckmässig aus solch hochwertigem Gleitlagermaterial, daß ihr Auswechseln während der Lebensdauer des Prüfadapters nicht erforderlich wird. Die Laufbuchse 12 bietet dabei immer noch den bedeutsamen Vorteil, daß die Hülse 11 aus kostengünstigem und leicht zu verformendem Material, wie beispielsweise Messing oder Stahl, bestehen kann, wogegen die im Betrieb hoch beanspruchte Laufbuchse 12 aus hochwertigem, teurem Material hergestellt werden kann, das besonders gute Gleiteigenschaften aufweist und im Betrieb nur unbedeutendem Verschleiß unterliegt.

Der einzige Kolben 25 dieses Kolbengliedes 13 ist hier nur in der Laufbuchse 12 gleitbar gelagert, doch kann ggf. auch vorgesehen sein, daß er auch an der einen Anschlag für die Laufbuchse 12 bildenden Sicke 32 der Hülse 11 noch in einem gewissem Umfang eine Gleitlagerung erfährt.

Der Federkontaktstift 10 nach Fig. 5 entspricht dem nach Fig.1 mit dem Unterschied, daß die vorzugsweise metallische Hülse 11 anstelle der Sicke 32 eine eine Innenringschulter 55 bildende Durchmesserabstufung aufweist, wie es entsprechend auch bei der Hülse 11 nach Fig. 3 der Fall ist. Diese Hülse 11 besteht also aus den beiden unterschiedliche Innendurchmesser und entsprechend auch unterschiedliche Aussendurchmesser aufweisenden kreiszylindrischen Bereichen 45 und 47 und dem gelochten Boden 48. Die Innenringschulter 55 dient als Anschlag für die Laufbuchse 12, die durch Haftreibung in der Hülse 11 lösbar gehalten ist, so daß sie beim Herausziehen des Kolbengliedes 13 aus der Hülse 11 mit herausgezogen wird.

Der Federkontaktstift 10 nach Fig.6 entspricht dem nach Fig.3 mit dem einzigen Unterschied, daß die Hülse 11 nicht aus Nichtmetall, sondern aus Metall besteht.

**Ansprüche**

1. Federkontaktstift für einen Prüfadapter zum Kontaktieren von elektrischen oder elektronischen Prüflingen, wie Leiterplatten, integrierten Schaltkreisen oder dgl., welcher Federkontaktstift eine Hülse aufweist, in der ein Kolbenglied gleitbar geradegeführt und ständig durch mindestens eine in der Hülse angeordnete Feder abgestützt ist, wobei in die Hülse eine Laufbuchse eingesetzt ist, in der ein Kolben des Kolbengliedes gleitbar geradegeführt ist, und wobei ferner das Kolbenglied in der Hülse lösbar angeordnet ist, dadurch gekennzeichnet, daß die Laufbuchse (12) im vorderen Endbereich der Hülse (11) angeordnet und zur exakten Geradführung des Kolbens (25) oder eines vorderen Kolbens (43) des Kolbengliedes (13) ausgebildet ist, und daß das Kolbenglied (13) aus der Hülse (11) unter Überwindung von zwischen der Laufbuchse (12) und der Hülse vorliegender Ruhereibungskraft und/oder unter seitlichem Ausbiegen mindestens eines federnden Anschlages (39; 52) axial herausziehbar ist.

2. Federkontaktstift nach Anspruch 1, dadurch gekennzeichnet, daß die Laufbuchse (12) in der Hülse lösbar angeordnet ist.

3. Federkontaktstift nach Anspruch 2, dadurch gekennzeichnet, daß die Laufbuchse (12) in der Hülse (11) so gehalten ist, daß sie ohne vorangehende Abnahme irgendeines Teiles nur unter Anwendung von Kraft aus der Hülse herausziehbar und sie oder eine andere Laufbuchse in die Hülse unter Anwendung von Kraft wieder einsetzbar ist, ohne daß hierdurch die Hülse eine bleibende Gestaltsänderung erfährt.

4. Federkontaktstift nach Anspruch 2 oder 3, dadurch gekennzeichnet, daß das Kolbenglied (13) eine Schulter (40; 40'; 49) aufweist, die durch die Feder (14) an das hintere Ende der Laufbuchse (12) oder an eine Innenschulter (59) der Laufbuchse (12) andrückbar ist und beim Herausziehen des Kolbengliedes (13) aus der Hülse die Laufbuchse (12) mit aus der Hülse (11) herausschiebt.

5. Federkontaktstift nach einem der vorhergehenden Ansprüche, dadurch gekennzeichnet, daß das Kolbenglied (13) in axialem Abstand von dem vorderen Kolben (43) einen rückwärtigen Kolben (44) aufweist, der in einer durch die Hülse (11) gebildeten Laufbahn geradegeführt gleitgelagert ist.

6. Federkontaktstift nach einem der vorhergehenden Ansprüche, dadurch gekennzeichnet, daß die Hülse (11) oder die Laufbuchse (12) mindestens einen als Begrenzung der Auswärtsbewegung des Kolbengliedes (13) dienenden federnden Anschlag (39; 52), der vorzugsweise zungenförmig ausgebildet ist, aufweist, der durch die Laufbuchse (12) bzw. das Kolbenglied (13) wenn sie bzw. es unter Kraftanwendung aus der Hülse herausgezogen wird, seitlich ausbiegbar ist, wobei dieser federnde Anschlag vorzugsweise so ausgebildet ist, daß er auch beim axialen Einsetzen der Laufbuchse bzw. des Kolbengliedes durch sie bzw. es nach aussen biegbar ist.

7. Federkontaktstift nach einem der vorhergehenden Ansprüche, dadurch gekennzeichnet, daß die Hülse (11) eine Innenschulter (55; 55') aufweist, die einen Anschlag für das rückwärtige Ende der Laufbuchse bildet.

8. Federkontaktstift nach Anspruch 7, dadurch gekennzeichnet, daß die Innenschulter (55) der Hülse durch eine Durchmesserabstufung der Hülse (11) gebildet ist.

9. Federkontaktstift nach Anspruch 7, dadurch gekennzeichnet, daß die Innenschulter der Hülse (11) durch eine Sicke (32) gebildet ist.

10. Federkontaktstift nach einem der vorhergehenden Ansprüche, dadurch gekennzeichnet, daß alle Teile des Federkontaktstiftes metallisch sind.

11. Federkontaktstift nach einem der Ansprüche 1 bis 9, dadurch gekennzeichnet, daß die Hülse (11) des Federkontaktstiftes aus Nichtmetall, vorzugsweise aus elektrisch isolierendem Kunststoff oder Keramik besteht.

12. Federkontaktstift nach einem der vorhergehenden Ansprüche, dadurch gekennzeichnet, daß die Feder (14) an der rückwärtigen, vorzugsweise sich in axialer Richtung verjüngenden Stirnseite des Kolbengliedes (13) anliegt.

13. Federkontakstift nach einem der Ansprüche 1 oder bis 11, dadurch gekennzeichnet, daß die Laufbuchse (12) in der Hülse (11) nichtlösbar angeordnet ist (Fig .4).

14. Federkontaktstift nach einem der vorhergehenden Ansprüche, dadurch gekennzeichnet, daß er ein Federkontaktstift ist, dessen Hülse (11) zum direkten Einsetzen in eine Bohrung mindestens einer Platte eines Prüfadapters ausgebildet ist.

FIG.2

FIG.1

EP 0 405 323 A2

FIG.3

FIG.4

11

FIG.6

FIG.5